# EUROPÄISCHE PATENTANMELDUNG

(11) **EP 2 388 918 A2**
(43) Veröffentlichungstag der Anmeldung: **23.11.2011**
(21) Anmeldenummer: 11162050.6
(22) Anmeldetag: 12.04.2011
(51) Int. Cl.: H03K 17/689

(54) **Treiber für ein Leistungshalbleitermodul**

(30) Priorität: 20.05.2010 DE 102010029177
(71) Anmelder: SEMIKRON Elektronik GmbH & Co. KG, 90431 Nürnberg (DE)
(72) Erfinder: Berberich, Sven Dr., 91080 Spardorf (DE); Kalkmann, Bernhard, 91126 Schwabach (DE)

(57) **Zusammenfassung**

Ein Treiber (2) für ein Leistungshalbleitermodul mit mindestens einem Leistungshalbleiterschalter (6) enthält
- einen eine Schaltenergie (38) und ein Logiksignal (42) potentialgetrennt zu einem Gleichspannungszwischenkreis (44) und einem Logikdekoder (46) übertragenden Piezotransformator (14),
- einen den Piezotransformator (14) durch ein eine Arbeitsfrequenz (fₐ) aufweisendes Leistungssignal (36) speisenden Wandler (16),
- wobei das Leistungssignal (36) die Schaltenergie (38) beinhaltet und gemäß dem Logiksignal (42) amplitudenmoduliert ist,
- wobei der Wandler (16) derart mit mindestens einem, die Arbeitsfrequenz (fₐ) bestimmenden parasitären Element (Cᵢₙ) des Piezotransformators (14) zusammenwirkt, dass die Arbeitsfrequenz (fₐ) der Resonanzfrequenz (fᵣ) des Piezotransformators (14) entspricht.

## Beschreibung

Die Erfindung betrifft einen Treiber für ein Leistungshalbleitermodul.

Zur Ansteuerung eines Leistungshalbleitermoduls mit mindestens einem Leistungshalbleiterschalter, z.B. in Form eines IGBT (insulated gate bipolar transistor) ist eine sogenannte Treiberschaltung oder kurz ein Treiber notwendig. Der Treiber erzeugt in der Regel aus einem an dessen Eingang zugeführten logischen Schaltsignal schwacher Leistung ein am Ausgang an den Leistungshalbleiter anzulegendes Signal mit deutlich erhöhter Leistung, welche beispielsweise zum tatsächlichen Schalten eines IGBT notwendig ist. Außerdem übernimmt der Treiber eine galvanische bzw. Potentialtrennung zwischen seinem Ein- und Ausgang, und damit z.B. zwischen dem Schaltsignal bzw. der Ansteuerlogik und dem Leistungshalbleiter, welcher z.B. auf Hochspannungspotential arbeitet.

Bekannt ist es, innerhalb eines Treibers z.B. ein leistungsstarkes Schaltsignal über eine Übertragerstrecke zu übertragen. Der Übertrager bewirkt die Potentialtrennung im zu übertragenenden Signal. Zusätzlich zum Schaltsignal werden eventuell noch Logiksignale übertragen, z.B. eine gemessene Spannung oder Temperatur, ein Soft-Off-Signal oder ähnliches. Die Übertragung kann von der Primär- zur Sekundärseite oder umgekehrt erfolgen.

Für die Realisierung von Treiberschaltungen in der Leistungselektronik sind verschiedene Alternativen bekannt, deren Kernzweck jeweils die Ansteuerung eines Schalteingangs eines Leistungshalbleiterschalters, z.B. des Gate eines IGBT, ist. Bekannt ist z.B. eine komplementäre Source-Folger-Booster-Stufe mit Kleinleistungs-MOSFETs, komplementäre Drain- oder Kollektor-Folger-Stufen und Totem-Pole-Treiber mit MOSFETs oder Bipolartransistoren. Auf der Primärseite des Treibers, d.h. eingangsseitig, erfolgt in der Regel die logische Ansteuerung des Schalteingangs. Hier sind z.B. Zeitglieder für Verzögerungs-, Verriegelungs- sowie Mindestein- und auszeiten vorgesehen.

Weiter enthält der Treiber ein Potentialtrennglied, gegebenenfalls mit vor- und nachgeschalteter Impulsformung und einen Generator, der eine positive und/oder negative Steuerspannung für den Schalteingang erzeugt. Sekundärseitig, d.h. auf der dem Ausgang zugewandten Seite des Treibers ist z.B. ein Gate-Überspannungsschutz, auch in Verbindung mit einer aktiven Clamping-Beschaltung, angeordnet. Als Potentialtrennglieder werden für die potentialgetrennte Informations- und Energieübertragung in klassischer Weise magnetische Transformatoren oder Optokoppler eingesetzt. Ein magnetischer Transformator bzw. Übertrager wird hierbei durch eine Push/Pull-Endstufe mit einem Rechtecksignal angesteuert bzw. wird ein Rechtecksignal über den Übertrager übertragen.

Aus der DE 10 2006 032 392 A1 ist alternativ ein Konzept bekannt, bei dem ein magnetischer Transformator bzw. Übertrager im Treiber durch einen Piezotransformator ersetzt wird, welcher anstelle dessen zur Leistungs- und Signalübertragung und Potentialtrennung genutzt wird. Ein wichtiges Kriterium für den Einsatz von Piezotransformatoren ist hierbei ein hoher Wirkungsgrad der Schaltung, in welcher der Transformator eingesetzt wird. Um hier die bestmöglichste Effizienz zu erzielen, muss der Transformator bei seiner Resonanzfrequenz betrieben werden.

Aufgabe der Erfindung ist es, einen verbesserten Treiber für einen Leistungshalbleiterschalter anzugeben.

Die Erfindung beruht auf der Idee, nicht alleine den Transformatortyp in einem bestehenden Treiber bzw. -konzept auszuwechseln und letzteren durch Zusatzaufwand für den neuen Transformator zu ertüchtigen, sondern eine Systemlösung zu schaffen, die den bekannten Systemwirkungsgrad von Leistungsmodultreiberschaltungen verbessert.

Die Aufgabe wird gemäß Patentanspruch 1 gelöst durch einen Treiber für einen Leistungshalbleiterschalter, der einen Piezotransformator enthält. Der Treiber ist so ausgebildet, dass der Piezotransformator eine Schaltenergie und ein Logiksignal potentialgetrennt zu einem Gleichspannungszwischenkreis und einem Logikdekoder überträgt. Mit anderen Worten wird also der Piezotransformator an seinem Eingang mit Schaltenergie und einem aufmodulierten Logiksignal versorgt, und ist mit seinem Ausgang auf einen Gleichspannungszwischenkreis und einen Logikdekoder geführt. Der Piezotransformator überträgt also insbesondere auch die benötigte Schaltenergie zur Betätigung des Leistungshalbleiterschalters, so dass sekundärseitig eine zusätzliche Leistungsversorgung nicht mehr erforderlich ist.

Der Treiber enthält außerdem einen Wandler, welcher den Piezotransformator mit einem Leistungssignal speist. Das Leistungssignal weist hierbei eine Arbeitsfrequenz auf. Das Leistungssignal beinhaltet die im Treiber zum Leistungshalbleiterschalter zu transportierende Schaltenergie. Das Leistungssignal ist gemäß dem Logiksignal amplitudenmoduliert. Der Wandler wirkt derart mit mindestens einem parasitären Element des Piezotransformators zusammen, dass dieses Element die Arbeitsfrequenz zumindest mitbestimmt. Der Wandler ist derart ausgestaltet bzw. dimensioniert, dass die sich ergebende Arbeitsfrequenz der Resonanzfrequenz des Piezotransformators entspricht.

Erfindungsgemäß wird also ein in einem resonanten Treiber systemintegrierter Piezotransformator vorgeschlagen, um einen hocheffizienten Treiber für die Leistungselektronik zu realisieren. Erfindungsgemäß werden die Systemkomponenten so aufeinander abgestimmt, dass die Treiberschaltung bzw. der Piezotransformator ein Leistungssignal bzw. die Schaltleistung bei einer Frequenz bzw. einem möglichst schmalen Frequenzband, nämlich der Resonanzfrequenz des Piezotransformators, überträgt. Teil der Erfindung ist, das Leistungssignal vom Logiksignal zu trennen. Für die Übertragung der Logikinformation ist der Wirkungsgrad nicht entscheidend, so dass diese insbesondere bei einer anderen, nämlich nicht der Resonanzfrequenz, übertragen werden kann.

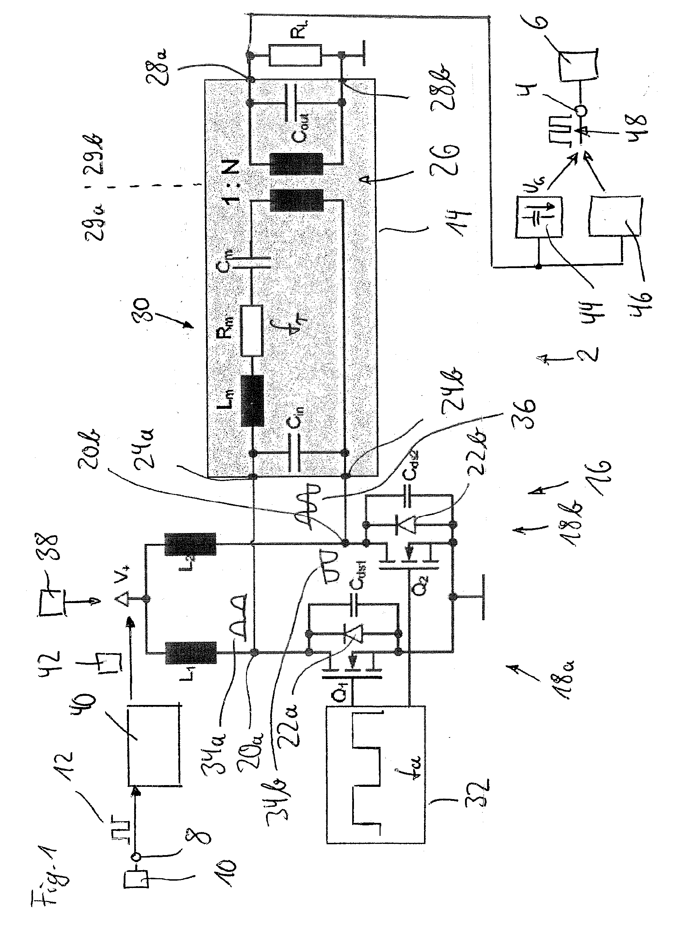

Die Erfindung beruht dabei weiterhin auf folgender Erkenntnis: Piezotransformatoren lassen sich in guter Näherung im Ersatzschaltbild (siehe Fig.1) als Reihenschwingkreis (Lₘ, Rₘ, Cₘ) mit einem idealen Übertrager (1:N) sowie einer Eingangs- (Cᵢₙ) und Ausgangskapazität (Cₒᵤₜ) beschreiben. Der den Piezotransformator speisende Teil des Treibers wird als Teil eines resonant arbeitenden Wandlers ausgeführt. Dieser resonante Teil der Treiberschaltung wird auf die eingangsseitigen Schwingkreiselemente des Ersatzschaltbildes des Piezotransformators abgestimmt, so dass der Piezotransformator in Resonanz betrieben wird. Der Piezotransformator, bzw. im Ersatzschaltbild dessen parasitäre Elemente, z.B. dessen Eingangskapazität bildet den anderen Teil des Wandlers. Die Systemgrenzen zwischen Piezotransformator und dessen ansteuernder Schaltung verschwimmen. Gemäß der Erfindung sind Teile des Piezotransformators und der zusätzlichen Beschaltung zu einem insgesamt resonant arbeitenden Wandler kombiniert, wobei die parasitären Elemente des Piezotransformators zur Bestimmung der Arbeitsfrequenz, z.B. im Rahmen eines Schwingkreiselementes mit weiteren diskreten bzw. konkret gewählten Elementen des Wandlers zusammenarbeiten. Mit anderen Worten werden also Ersatzschaltbildelemente des Piezotransformators als Bauelemente bzw. Bestandteile des Wandlers benutzt, um einen Teil des Resonanzwandlers zu bilden.

Bei einer Verschiebung der Resonanzfrequenz (fᵣ) des Piezotransformators, z.B. durch Last- oder Temperaturschwankungen wird die einstellbare Arbeitsfrequenz der Treiberschaltung über eine Regelung angepasst. Eine solche kann z.B. über einen Mikrocontroller realisiert werden. Der resonant arbeitende Wandler ist hinsichtlich seiner einstellbaren Arbeitsfrequenz über eine Regelung derart auf mindestens ein, die Arbeitsfrequenz bestimmendes parasitäres Element des Piezotransformators angepasst, dass die Arbeitsfrequenz stets der Resonanzfrequenz des Piezotransformators entspricht.

Die Regelung erfolgt derart, dass ein den Piezotransformator ansteuernder Teil des Wandlers ein abstimmbares Element enthält, z.B. eine veränderliche Induktivität. Diese wirkt dann mit dem, dem Piezotransformator zugehörigen Teil des Wandlers, z.B. der Eingangskapazität zusammen, so dass schlussendlich das Gesamtsystem abstimmbar ist. Die veränderlichen elektrischen (parasitären, nicht beeinflussbaren) Eigenschaften des Piezotransformators werden erfindungsgemäß innerhalb des Wandlers bewusst genutzt, bzw. fließen in definierter Weise in die geregelte Frequenzabstimmung des Wandler ein.

Somit ist sichergestellt, dass der Piezotransformator stets im optimalen Arbeitspunkt, nämlich bei seiner aktuellen Resonanzfrequenz, und damit hocheffizient betrieben wird.

Die Erfindung beruht außerdem auf der grundlegenden Idee, das im Treiber zu übertragende leistungsstarke Schaltsignal in ein reines Leistungssignal ohne Schaltinformation und ein leistungsschwaches Logiksignal, das die Schaltinformation enthält, aufzusplitten. Die Schaltinformation wird dann amplitudenmoduliert übertragen. Die Schaltleistung wird ununterbrochen übertragen, es finden also keine Pausen in der Leistungsübertragung statt. Erst sekundärseitig wird die Leistung in einem Gleichspannungszwischenkreis gehalten und gemäß den Schaltinformationen zu einem Schaltsignal zusammengesetzt.

Die Schaltinformation wird über den Logikdekoder generiert bzw. aus dem übertragenen Leistungssignal zurückgewonnen. In Kombination mit der Nachführung der Arbeitsfrequenz zur Resonanzfrequenz gemäß oben ist es so möglich, die Leistung stets und ununterbrochen bei der optimalen Arbeitsfrequenz des Piezotransformators, nämlich dessen Resonanzfrequenz, mit bestmöglichem Wirkungsgrad zu übertragen und so die Systemleistung zu optimieren. Die eigentliche Schaltinformation wird als Logiksignal amplitudenmoduliert dem Leistungssignal überlagert und durch den Logikdekoder sekundärseitig wiedergewonnen. Am Ausgang des Gleichspannungszwischenkreises wird dann das eigentliche Schaltsignal für den Leistungshalbleiterschalter anhand des Logiksignals wieder rekonstruiert und mit der Schaltenergie zu einem Leistungssignal kombiniert.

Die dauerhafte Übertragung der Schaltenergie erfolgt z.B. dadurch, dass der Piezotransformator stets mit einem Eingangssignal mit von Null verschiedener Amplitude betrieben wird. Für die Aufmodulation der Schaltinformation wird die Amplitude lediglich auf stets von Null verschiedene Werte erhöht und abgesenkt.

Die Erfindung ermöglicht es, durch eine Lösung bestehend aus einem Piezotransformator und einem resonanten Treiber einen Systemwirkungsgrad von über 60% zu erzielen.

Die Frequenzanpassung der Arbeitsfrequenz über einen Mikrokontroller ist für einen Piezotransformator deshalb sinnvoll, um diesen stets bei seiner aktuellen Resonanzfrequenz zu betreiben. Verschiebungen der Resonanzfrequenz können beispielsweise durch Laständerung, Temperaturänderung usw. herbeigeführt werden. Bei herkömmlichen Treibern ist dies nicht vorgesehen, da eine Frequenznachführung bei magnetischen Transformatoren unnötig ist.

Eine Möglichkeit der Anpassung der Arbeitsfrequenz ist z.B. die dynamische Anpassung der Resonanzkreiselemente im System aus Wandler und Piezotransformator bzw. dessen parasitären Elementen. Eine Realisierung kann z.B. dadurch geschehen, dass den Piezotransformator beschaltende Teilkapazitäten oder Teilwiderstände als diskret realisierte abstimmbare Bauelemente vorgesehen werden.

In einer bevorzugten Ausführungsform enthält das Logiksignal ein Schaltsignal für mindestens einen Leistungshalbleiterschalter, das Schaltsignal enthält die Schaltenergie für alle Leistungshalbleiterschalter gemeinsam. Mit anderen Worten werden also durch den Treiber z.B. zwei Leistungshalbleiterschalter gemeinsam bedient; dies sind z.B. High- und Low-Side-Schalter einer Halbbrücke. Die Schaltenergie wird hierbei im Leistungssignal für beide Leistungsschalter gleichmäßig übertragen, d.h. der Zwischenkreis im Treiber versorgt beide Leistungshalbleiterschalter. Das Logiksignal enthält dann, z.B. in sekundärseitig unterscheidbarer Kodierung, gemeinsam die getrennten Schaltsignale für den jeweiligen Leistungshalbleiterschalter. Das Logiksignal kann aber auch noch andere Signalkomponenten, wie z.B. den oben genannten Soft/Off-Befehl, einen kodierten Temperatur- oder Spannungswert usw. enthalten. Die beiden Schaltsignale sowie sonstige Signale werden im Logikdekoder wieder voneinander separiert. Von Vorteil ist somit, dass sämtliche Information und die gesamte Leistung über den einzigen Piezotransformator übertragen werden und für zusätzliche Informationskanäle beispielsweise keine separaten Optokoppler oder ähnliches notwendig sind.

In einer weiteren bevorzugten Ausführungsform ist das Leistungssignal sinusförmig. Die Schwingung weist hierbei eine Arbeitsfrequenz auf, die der Resonanzfrequenz des Piezotransformators entspricht. Da ein verwendeter Piezotransformator in der Regel eine hohe mechanische Güte aufweist, filtert er aus einem zu übertragenden Signal sämtliche Signalanteile, die nicht der Resonanzfrequenz entsprechen, entsprechend stark heraus bzw. setzt diese in i.d.R. thermische Verluste um. Ein Rechtecksignal mit Resonanzfrequenz würde durch den Piezotransformator ohnehin stark geglättet und die entsprechend höherfrequenten Signalanteile als Verluste im Piezotransformator umgesetzt. Die Ansteuerung mit einem sinusförmigen Leistungssignal ist daher im Hinblick auf Verlustleistung optimal.

Im Vergleich zu herkömmlichen Treibern entfällt damit im erfindungsgemäßen Treiber auch die Push/Pull-Endstufe. Es erfolgt damit kein hartes Schalten und keine Rechtecksignalübertragung mehr.

In einer weiteren bevorzugten Ausführungsform weist der Wandler eine Versorgungsspannung auf, welche die Schaltenergie liefert und welche außerdem gemäß dem Logiksignal amplitudenmoduliert ist. Sowohl die Einspeisung der Leistung für die Schaltenergie als auch die Einspeisung des Logiksignals in das Leistungssignal ist so besonders einfach gelöst.

In einer weiteren Ausführungsform weist der Wandler zwei parallele Zweige auf, wobei je ein Zweig zu einem Eingangspol des Piezotransformators führt, die Zweige gegentaktig arbeiten und jeder der beiden Zweige je eine Halbwelle des sinusförmigen Signals als Kombination von Leistungs- und Logiksignal liefert. Mit anderen Worten erfolgt also die Signalkonstruktion des Eingangssignals des Piezotransformators aus zwei parallelen Zweigen

In einer bevorzugten Ausführungsform enthält jeder der Zweige eine an die Versorgungsspannung angeschlossene Reihenschaltung einer Induktivität, eines Knotens und eines Schalters. Der Knoten zweigt hierbei zu je einem der zwei Pole des Eingangs des Piezotransformators ab. Die Induktivität bestimmt zusammen mit einer parasitären Eingangskapazität des Piezotransformators die Arbeitsfrequenz. Das parasitäre Element des Piezotransformators, welches also mit dem Wandler zusammenwirkt, ist dessen parasitäre Eingangskapazität.

Erfindungsgemäß ist die Nutzung des effizienten Zero-Voltage-Switching (ZVS) Konzepts möglich. Bei bekannten Konzepten herkömmlicher Treiber mit magnetischen Übertragern entstehen beispielsweise bei 6W Ansteuerleistung 3W Treiberverlustleistung, also 50% Verlustleistung. In Lösungen mit magnetischen Transformatoren werden Leistungen mit ca. 50% Wirkungsgrad übertragen. Bei Nutzung von ZVS werden hierbei lediglich Verluste von etwa 0,2% anfallen.

Insbesondere die oben genannte Schaltung eignet sich daher, den Schalter nach dem ZVS-Prinzip zu betreiben und damit in einer bevorzugten Ausführungsform einen nach dem ZVS-Prinzip arbeitenden Wandler vorzusehen. Zum Beispiel ist in der oben genannten Ausführungsform jeder einzelne Zweig eine ZVS-Schaltung. Hierdurch werden die Systemverluste im gesamten Treiber weiter gesenkt, da jeweils hinsichtlich der Spannung leistungsfreies Schalten gewährleistet wird.

Für eine weitere Beschreibung der Erfindung wird auf die Ausführungsbeispiele der Zeichnungen verwiesen. Es zeigen, jeweils in einer schematischen Prinzipskizze:
Fig.1 einen erfindungsgemäßen Treiber,
Fig.2 verschiedene Signalverläufe im Treiber gemäß Fig. 1,
Fig.3 den Signalverlauf b) aus Fig.2 im Detail.

Fig. 1 zeigt einen Treiber 2, an dessen Ausgang 4 ein Leistungshalbleiterschalter 6 angeschlossen ist. Der Eingang 8 des Treibers 2 wird von einer Logikschaltung 10 mit einem logischen, leistungsschwachen Schaltsignal 12 versorgt, welches die Ein- und Ausschaltkommandos für den Leistungshalbleiterschalter 6 in Form von steigenden oder fallenden Flanken beinhaltet. Im Beispiel ist das Schaltsignal 12 ein PWM-Signal mit einer Frequenz im Bereich 5 bis 100 KHz.

Der Treiber 2 beinhaltet im Wesentlichen einen Piezotransformator 14, der in Fig. 1 durch sein Ersatzschaltbild dargestellt ist, sowie einen den Piezotransformator 14 ansteuerenden Wandler 16. Der Wandler 16 wird von einer Versorgungsspannung V+ versorgt und enthält zwischen dieser und einem Masseanschluss zwei parallele, identisch aufgebaute Zweige 18a,b. Jeder der Zweige 18a,b weist eine Reihenschaltung einer Induktivität L_{1,2} eines Knotens 20a,b und eines elektronischen Schalters Q_{1,2} auf. Jedem Schalter Q_{1,2} ist hierbei eine Body-und/oder Clamping-Diode 22a,b parallel geschaltet, die insbesondere ein ZVS der Schalter Q_{1,2} ermöglicht. Weiterhin ist den Schaltern Q_{1,2} jeweils eine Kapazität C_{ds1,2} parallel geschaltet, die die Driftzonenkapazität des Schalters Q_{1,2} - hier ein MOS(Metal-Oxide-Semiconductor)-Schalter - darstellt. Von den Knoten 20a,b zweigt jeweils eine Verbindung des jeweiligen Zweigs 18a,b zu je einem Eingangspol 24a,b des Piezotransformators 14 ab.

Der Piezotransformator 14 weist gemäß seinem Ersatzschaltbild eine parasitäre Eingangskapazität Cᵢₙ auf. Ein Reihenschwingkreis aus der Induktivität Lₘ, dem Widerstand Rₘ und der Kapazität Cₘ führt auf einen Übertrager 26 mit Übersetzungsverhältnis 1:N. Zwischen den Ausgangspolen 28a,b weist der Piezotransformator 14 eine parasitäre Ausgangskapazität Cₒᵤₜ auf. Die Ausgangspole 28a,b liefern das sekundärseitige Signal des Übertragers 26. Der Reihenschwingkreis 30 bestimmt die Resonanzfrequenz fᵣ des Piezotransformators 14, bei welcher dieser idealerweise zu betreiben ist, um eine möglichst verlustarme Übertragung der ihm zugeführten Leistung zu gewährleisten.

Die Schalter Q_{1,2} werden gegentaktig nach dem ZVS-Prinzip von einer Steuerschaltung 32 mit einer Arbeitsfrequenz fₐ angesteuert. Die Arbeitsfrequenz fₐ ist außerdem als Resonanzfrequenz der aus der jeweiligen Induktivität L_{1,2} und der Kapazität Cᵢₙ gebildeten Schwingkreise bestimmt. Mit anderen Worten sind die Werte der Induktivitäten L_{1,2} derart gewählt, dass sich zusammen mit der parasitären und damit fest vorgegebenen Eingangskapazität Cᵢₙ die entsprechende Resonanzfrequenz in Form der Arbeitsfrequenz fₐ ergibt. Die bestimmbaren Elementwerte sind also so gewählt, dass die Arbeitsfrequenz fₐ der Resonanzfrequenz fᵣ entspricht. Um eine Frequenznachführung zu ermöglichen, sind z.B. die Induktivitäten L_{1,2} gemäß Regelung durch einen nicht dargestellten Mikrokontroller abstimmbar.

Die Eingangskapazität Cᵢₙ als Teil eines Ersatzschaltbildes ist zwar eher ein virtuelles Element, aber dennoch dem Wandler 16 zuzurechnen. Mit anderen Worten erstreckt sich der Wandler 16 damit auch zu einem Teil in den Piezotransformator 14 hinein, die Grenzen zwischen Piezotransformator 14 und der diesen ansteuernden Schaltung verschwimmen.

Typische Frequenzen für die Resonanzfrequenz fᵣ liegen z.B. im Bereich von 1MHz.

Die Zweige 18a,b werden nach dem ZVS-Prinzip derart angesteuert, dass sich an den Knoten 20a bzw. 20b jeweils eine Halbwelle 34a,b eines Sinussignals 36 ergibt, welches somit zwischen den Eingangspolen 24a,b als vollständiges Sinussignal anliegt. Die Amplituden der Halbwellen 34a,b und somit des Sinussignals 36 werden durch die Versorgungsspannung V+ vorgegeben. Diese besitzt eine hohe Leistung, so dass das Sinussignal 36 ein Leistungssignal ist, welches die eingespeiste Schaltenergie 38 zum Ausgang 4 transportiert.

Die Versorgungsspannung V+ hat jedoch noch eine Doppelfunktion, da diese über einen Modulator 40 gemäß der Information eines Logiksignals 42 amplitudenmoduliert wird. Das Logiksignal 42 beinhaltet hierbei insbesondere das Schaltsignal 12 für den Leistungshalbleiter 6 sowie in nicht dargestellten Ausführungsformen zusätzliche Logikinformationen, welche von der Primärseite 29a aus zu den Ausgangspolen 28a,b und damit der Sekundärseite 29b des Treibers 2 zu transportieren sind.

Am Ausgangspol 28a,b liegt damit ein kombiniertes Leistungs-und Logiksignal vor, welches sowohl auf einen Gleichspannungszwischenkreis 44 als auch auf einen Logikdekoder 46 geführt wird. Hieraus wird schlussendlich das eigentliche leistungsbehaftete, gemäß dem Schaltsignal 12 getaktete Schaltsignal 48 erzeugt, welches tatsächlich dem Leistungshalbleiter 6 zugeführt wird.

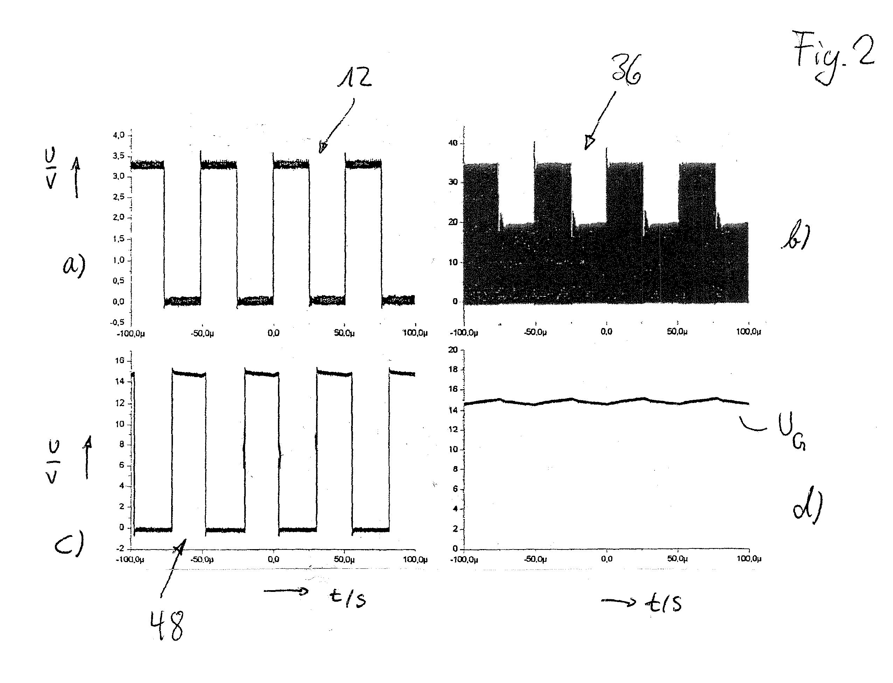

Fig. 2 zeigt die Verläufe verschiedener Signale bzw. Spannungen über der Zeit t, nämlich zunächst im Diagramm a) das Schaltsignal 12 mit einer Frequenz von 20kHz, mit welcher der Leitungshalbleiterschalter 6 zu schalten ist. Aufgetragen ist hierbei jeweils die Spannung U des jeweiligen Signals in Volt für alle vier Diagramme.

In einem zweiten Diagramm b) ist das Leistungssignal 36 gezeigt, welches eine Grundschwingung der Frequenz 2MHz aufweist, welche mit Hilfe des Schaltsignals 12 amplitudenmoduliert ist. Die Schaltenergie wird dauerhaft bzw. ununterbrochen übertragen, da die Signalamplitude stets von Null verschieden ist und mindestens eine Amplitude des Werts A0 aufweist. So entsteht zunächst ein Signal, das dauerhaft Energie zur Sekundärseite 29b überträgt. Der sekundärseitige Gleichspannungszwischenkreis 44 wird also von der Primärseite 29a her dauerhaft nachgeladen bzw. ununterbrochen mit Energie versorgt. Eine zusätzliche sekundärseitige Einspeisung von Schaltenergie ist damit nicht notwendig. Die Energieversorgung verläuft alleine über den Piezotransformator 14.

Um diesem Grundsignal die Schaltinformation hinzuzufügen, wird das Signal zwischen der Amplitude A0 und der größeren Amplitude A1 variiert bzw. moduliert.

Das Diagramm c) zeigt das Ausgangssignal des Logikdekoders 44 als rekonstruiertes Schaltsignal 12 bzw. tatsächliches Schaltsignal 48, welches eine hohe Leistung beinhaltet und zum tatsächlichen Schalten auf den Leistungshalbleiterschalter 6 gegeben wird.

Das Diagramm d) zeigt hierbei die Ausgangsgröße des Gleichspannungszwischenkreises 44 stellvertretend für die aus dem übertragenen Leistungssignal 36 bezogene Gleichspannungsleistung im Gleichspannungszwischenkreis 33.

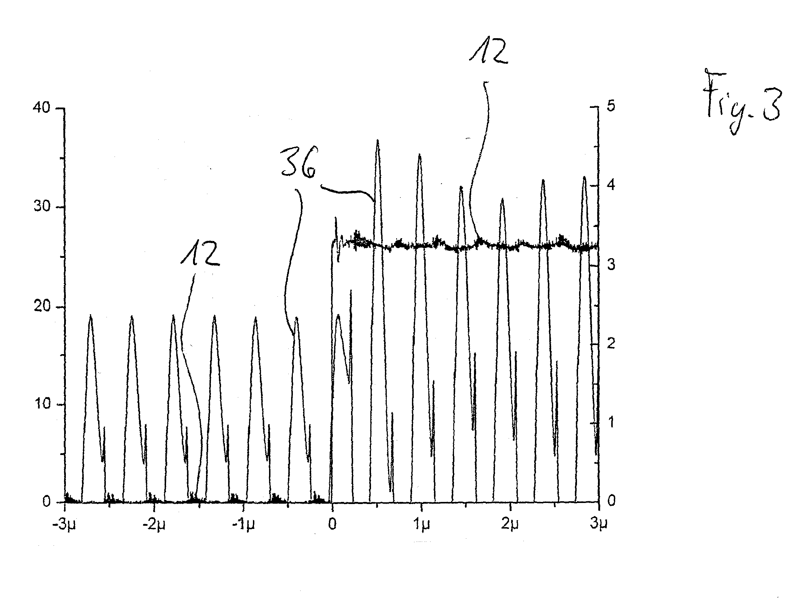

Fig. 3 zeigt einen vergrößerten Ausschnitt aus Fig. 2b zusammen mit einem vergrößerten Ausschnitt aus Fig. 2a, nämlich das Schaltsignal 12 als Modulationsgröße und das Leistungssignal 36 als Ergebnis der Aufmodulation des Schaltsignals 12 auf das hochfrequente, aus der Versorgungsspannung V+ erzeugte Trägersignal der Arbeitsfrequenz fₐ.

### Bezugszeichenliste

- 2: Treiber
- 4: Ausgang
- 6: Leistungshalbleiterschalter
- 8: Eingang
- 10: Logikschaltung
- 12: Schaltsignal
- 14: Piezotransformator
- 16: Wandler
- 18a,b: Zweig
- 20a,b: Knoten
- 22a,b: Clamping-Diode
- 24a,b: Eingangspol
- 26: Übertrager
- 28a,b: Ausgangspol
- 29a: Primärseite
- 29b: Sekundärseite
- 30: Reihenschwingkreis
- 32: Steuerschaltung
- 34a,b: Halbwelle
- 36: Leistungssignal
- 38: Schaltenergie
- 40: Modulator
- 42: Logiksignal
- 44: Gleichspannungszwischen kreis
- 46: Logikdekoder
- 48: Schaltsignal

- V+: Versorgungsspannung
- L1,2,m: Induktivität
- Q1,2: Schalter
- Cds1,2,m: Kapazität
- Cin: Eingangskapazität
- Cout: Ausgangskapazität
- RL: Lastwiderstand
- Rm: Widerstand
- fr: Resonanzfrequenz
- fa: Arbeitsfrequenz
- t: Zeit
- U,G: Spannung
- A0,1: Amp

## Patentansprüche

1. Treiber (2) für ein Leistungshalbleitermodul mit mindestens einem Leistungshalbleiterschalter (6),
- mit einem eine Schaltenergie (38) und ein Logiksignal (42) potentialgetrennt zu einem Gleichspannungszwischenkreis (44) und einem Logikdekoder (46) übertragenden Piezotransformator (14),
- mit einem den Piezotransformator (14) durch ein eine Arbeitsfrequenz (fₐ) aufweisendes Leistungssignal (36) speisenden Wandler (16),
- wobei das Leistungssignal (36) die Schaltenergie (38) beinhaltet und gemäß dem Logiksignal (42) amplitudenmoduliert ist,
- wobei der resonant arbeitende Wandler (16) hinsichtlich seiner einstellbaren Arbeitsfrequenz (fₐ) über eine Regelung derart auf mindestens ein, die Arbeitsfrequenz (fₐ) bestimmendes parasitäres Element (Cᵢₙ) des Piezotransformators (14) angepasst ist, dass die Arbeitsfrequenz (fₐ) stets der Resonanzfrequenz (fᵣ) des Piezotransformators (14) entspricht.

2. Treiber (2) nach Anspruch 1, bei dem das Logiksignal (42) ein Schaltsignal (12) für mindestens einen Leistungshalbleiterschalter (6) enthält, und das Leistungssignal (36) die Schaltenergie (38) für alle Leistungshalbleiterschalter (6) gemeinsam enthält.

3. Treiber (2) nach einem der vorhergehenden Ansprüche, bei dem das Leistungssignal (38) sinusförmig ist.

4. Treiber (2) nach einem der vorhergehenden Ansprüche, bei dem der Wandler (16) eine gemäß dem Logiksignal (42) amplitudenmodulierte, die Schaltenergie (38) liefernde Versorgungsspannung (V+) aufweist.

5. Treiber (2) nach Anspruch 4, bei dem der Wandler (16) zwei, zu je einem Eingangspol (24a,b) des Piezotransformators (14) führende, gegentaktig arbeitende, je eine Halbwelle (34a,b) des sinusförmigen Leistungssignals (38) liefernde parallele Zweige (18a,b) aufweist.

6. Treiber (2) nach Anspruch 5, bei dem der Zweig (18a,b) eine an die Versorgungsspannung (V+) angeschlossene Reihenschaltung einer Induktivität (L_{1,2}), eines zum Piezotransformator (14) abzweigenden Knotens (20a,b) und eines Schalters (Q_{1,2}) enthält, wobei die Induktivität (L_{1,2}) zusammen mit einer parasitären Eingangskapazität als parasitärem Element (Cᵢₙ) des Piezotransformators (14) die Arbeitsfrequenz (fₐ) bestimmt.

7. Treiber (2) nach einem der vorhergehenden Ansprüche, mit einem nach dem Zero-Voltage-Switching(ZVS)-Prinzip arbeitenden Wandler (16).
